# EUROPÄISCHE PATENTSCHRIFT

(11) **EP 3 679 772 B1**
(45) Veröffentlichungstag und Bekanntmachung des Hinweises auf die Patenterteilung: **14.06.2023**
(21) Anmeldenummer: 18759275.3
(22) Anmeldetag: 16.08.2018
(51) Int. Cl.: H05K 7/14, H01P 1/04, H01R 24/40

(54) **FELDGERÄT DER MESS- UND AUTOMATISIERUNGSTECHNIK MIT GALVANISCHER TRENNVORRICHTUNG**
FIELD DEVICE IN MEASUREMENT AND AUTOMATION TECHNOLOGY COMPRISING A GALVANIC ISOLATION DEVICE
APPAREIL DE TERRAIN DE LA TECHNIQUE DE LA MESURE ET DE L'AUTOMATISATION POURVU DE DISPOSITIF DE SÉPARATION GALVANIQUE

(30) Priorität: 04.09.2017 DE 102017120266
(43) Veröffentlichungstag der Anmeldung: 15.07.2020
(73) Patentinhaber: Endress+Hauser Flowtec AG, 4153 Reinach (CH)
(72) Erfinder: TANNER, Lukas, 4104 Oberwil BL (CH); KOLLMER, Daniel, 79689 Maulburg (DE); TANNER, Werner, 4415 Lausen (CH); PAETZOLD, Marita, 79588 Efringen-Kirchen (DE); BOSSE, Lüder, 4127 Birsfelden (CH)
(74) Vertreter: Hahn, Christian
(86) Internationale Anmeldenummer: PCT/EP2018/072215
(87) Internationale Veröffentlichungsnummer: WO 2019/042780

(56) Entgegenhaltungen:
- WO-A1-2016/174467
- US-A1- 2007 069 833
- Q. ZHANG ET AL: "Compact Broadside Coupled Directional Coupler Based on Coplanar CRLH Waveguides", JOURNAL OF ELECTROMAGNETIC WAVES AND APPLICATIONS, Bd. 23, Nr. 2-3, 3. April 2012 (2012-04-03), Seiten 267-277, XP055525397, NL ISSN: 0920-5071, DOI: 10.1163/156939309787604418

## Beschreibung

Die Erfindung betrifft ein Feldgerät der Mess- und Automatisierungstechnik umfassend eine elektronische Betriebsschaltung sowie eine Datenübertragungsvorrichtung, welche mittels einer Signalleitung verbunden sind, wobei die Signalleitung eine Trennvorrichtung zur galvanischen Trennung aufweist. Eine Trennvorrichtung einer solchen Signalleitung ist notwendig in Umgebungen mit explosiven Gasen, um die Voraussetzungen hinsichtlich bestehender Ex-i-bzw. Ex-d-Normen zu erfüllen.

Der Stand der Technik, gegeben beispielsweise durch die Druckschrift EP3029782A1, schlägt vor, Leiter einer eingangsseitigen Koaxialleitung und einer ausgangsseitigen Koaxialleitung auf einer Platine in Form einer hochfrequenztauglichen Leiterstruktur zusammenzuführen, wobei auf einer Seite der Platine ein Trennelement zur galvanischen Signaltrennung im Hinblick auf die Eingangs- sowie Ausgangsseite angeordnet ist.

Q.Zhang et al in "Journal of electromagnetic waves and applications", Bd.23, Nr. 2-3, 3.April 2012, Seiten 267-277, XP055525397, NL, ISSN: 0920-5071 zeigt einen Koppler mit koplanaren Wellenleitern.

Die WO2016/174467A1 zeigt eine Radiofrequenzantenne mit faltbarer Struktur.

Die Einrichtung eines zusätzlichen Trennelements auf einer Platine verkompliziert die Fertigung und kann hinsichtlich der Übertragungseigenschaften von Wechselspannungssignalen Nachteile aufweisen. Ein weiteres Beispiel ist aus US 2007/069833 A1 vorbekannt.

Aufgabe der Erfindung ist es daher, ein Feldgerät mit einer Signalleitung vorzuschlagen, bei welcher Erfordernisse einer Sicherheitsnorm auf einfache und robuste Weise umgesetzt werden. Die Aufgabe wird gelöst durch ein Feldgerät gemäß dem unabhängigen Anspruch 1.

Ein erfindungsgemäßes Feldgerät der Mess- und Automatisierungstechnik umfasst:
Ein Gehäuse mit einer Gehäusewand und mit mindestens einer Gehäusekammer, wobei die mindestens eine Gehäusekammer zumindest teilweise von der Gehäusewand umrandet ist;
eine Messelektronik, welche dazu eingerichtet ist, mindestens ein eine Messgröße repräsentierendes Messsignal zu erzeugen;
eine Datenübertragungsvorrichtung;
eine elektronische Betriebsschaltung, welche in einer ersten Gehäusekammer angeordnet ist und dazu eingerichtet ist, die Datenübertragungsvorrichtung und die Messelektronik zu betreiben sowie das Messsignal in mindestens einen Messwert zu wandeln;
wobei die Datenübertragungsvorrichtung außerhalb der ersten Gehäusekammer angeordnet ist und dazu eingerichtet ist, Daten mit der elektronischen Betriebsschaltung des Feldgeräts auszutauschen;
wobei die Datenübertragungsvorrichtung und die elektronische Betriebsschaltung über eine elektrische Signalleitung verbunden sind,
wobei die Signalleitung eine Mehrzahl von elektrischen Leitern aufweist, welche elektrischen Leiter dazu eingerichtet sind, ein Datensignal zwischen der Datenübertragungsvorrichtung und der elektronischen Betriebsschaltung zu übertragen,
wobei ein erster elektrischer Leiter zum Führen eines das Datensignal transportierenden ersten elektrischen Stroms eingerichtet ist, und wobei mindestens ein zweiter elektrischer Leiter zum Führen eines das Datensignal transportierenden zweiten elektrischen Stroms eingerichtet ist, welcher zweite elektrische Strom dem ersten elektrischen Strom entgegengesetzt ist,
wobei die Signalleitung eine Trennvorrichtung aufweist, welche Trennvorrichtung dazu eingerichtet ist, einen ersten, datenübertragungsvorrichtungsseitigen Signalleitungsabschnitt von einem zweiten, betriebselektronikseitigen Signalleitungsabschnitt zumindest teilweise galvanisch zu trennen,
wobei jeder elektrischer Leiter einen ersten, datenübertragungsvorrichtungsseitigen Leiterabschnitt und einen zweiten, galvanisch getrennten betriebselektronikseitigen Leiterabschnitt aufweist, wobei die Leiterabschnitte auf der Trennvorrichtung angeordnet sind,
wobei bei mindestens einem elektrischen Leiter der erste Leiterabschnitt und der zweite Leiterabschnitt galvanisch getrennt sind,
wobei
die Trennvorrichtung eine elektromagnetisch transparente Platte mit einer ersten Seitenfläche und einer zur ersten Seitenfläche parallelen zweiten Seitenfläche aufweist,
wobei im Bereich der Trennvorrichtung die Leiterabschnitte des ersten Signalleitungsabschnitts auf der ersten Seitenfläche angeordnet sind und wobei die Leiterabschnitte des zweiten Signalleitungsabschnitts auf der zweiten Seitenfläche angeordnet sind, wobei jeder erste Leiterabschnitt dem entsprechenden zweiten Leiterabschnitt bezüglich einer Seitenflächennormalen gegenübersteht,
wobei die Platte mindestens eine durch eine Sicherheitsnorm geforderte Mindestdicke oder Spannungsfestigkeit aufweist.

Bei einem elektrischen Leiter ohne Trennung kann der erste Signalleitungsabschnitt mit dem zweiten Signalleitungsabschnitt beispielsweise mittels einer in der elektromagnetisch transparenten Platte angeordneten Durchkontaktierung galvanisch verbunden sein. Eine galvanische Trennung ist entweder bei dem ersten Leiter oder bei dem mindestens einen zweiten Leiter oder bei allen Leitern eingerichtet und dient zum Blockieren von Gleichströmen oder niederfrequenten Strömen mit üblichen Frequenzen von Netzspannungen zwischen Datenübertragungsvorrichtung und elektronischer Betriebsschaltung.

Die Signalleitung ist dabei dazu eingerichtet, eine hohe Datenübertragungsrate zwischen der Datenübertragungsvorrichtung sowie der elektronischen Betriebsschaltung zu ermöglichen. Insbesondere sollte die Signalleitung dazu eingerichtet sein, Daten gemäß gängiger drahtloser Netzwerkprotokollfamilien wie beispielsweise IEEE 802.11 oder IEEE 802.15 übertragen zu können. Dadurch wird beispielsweise die Übertragung von Inhalten wie Webseiten oder größeren Dateien möglich.

Die elektromagnetisch transparente Platte kann beispielsweise ein Printed-Circuit-Board sein.

In einer Ausgestaltung ist die Sicherheitsnorm eine Norm aus folgender Liste:
Gerätesicherheitsnorm IEC 60664-1 des Jahres 2007 oder Ex-d-Norm nach IEC 60079-1 des Jahres 2014, oder Ex-i-Norm nach IEC 60079-11 des Jahres 2011 oder IEC 61010-1 des Jahres 2010.

In einer Ausgestaltung weist das Gehäuse eine zweite Gehäusekammer auf, welche von der ersten Gehäusekammer durch eine Innenwandung des Gehäuses getrennt ist,
wobei die Innenwandung eine zweite Signaldurchführung aufweist, durch welche die Signalleitung verläuft.

In einer Ausgestaltung weist jeder elektrische Leiter einen ersten, datenübertragungsvorrichtungsseitigen Leiterabschnitt und einen zweiten, galvanisch getrennten betriebselektronikseitigen Leiterabschnitt auf.

In einer Ausgestaltung umfasst die Datenübertragungsvorrichtung eine Antennenvorrichtung, welche dazu eingerichtet ist Hochfrequenzsignale zu empfangen und/oder zu senden,
wobei die Antennenvorrichtung auf einer Außenseite der Gehäusewand angeordnet ist,
wobei die Signalleitung durch eine erste Signaldurchführung in der Gehäusewand verläuft.

In einer Ausgestaltung verlaufen der erste elektrische Leiter und der zweite elektrische Leiter auf den Seitenflächen parallel zueinander,
und/oder wobei die Leiterabschnitte des ersten Signalleitungsabschnitts auf der ersten Seitenfläche parallel zu den Leiterabschnitten des zweiten Signalleitungsabschnitts auf der zweiten Seitenfläche verlaufen.

In einer Ausgestaltung sind das Gehäuse und die erste Signaldurchführung bzw. die zweite Signaldurchführung druckfest nach einer Ex-d-Norm, insbesondere nach IEC 60079-1, ausgestaltet,
wobei die Trennvorrichtung in der ersten Signaldurchführung bzw. zweiten Signaldurchführung angeordnet ist und druckfest vergossen ist.

Eine in einer Gehäusekammer auftretende Explosion kann somit in der Gehäusekammer oder zumindest im Gehäuse gehalten werden.

In einer Ausgestaltung sind dem ersten elektrischen Leiter zwei zweite elektrische Leiter zugeordnet, welche zweiten elektrischen Leiter bezüglich des ersten elektrischen Leiters auf gegenüberliegenden Seiten des ersten elektrischen Leiter angeordnet sind.

Auf diese Weise wird eine Abstrahlung eines Signals besser unterdrückt, wodurch das Signal/Rauschen-Verhältnis deutlich verbessert ist.

In einer Ausgestaltung ist die Platte aus einem dielektrischen Material gefertigt, wobei das Material insbesondere mindestens einen Stoff aus den folgenden Stoffgruppen aufweist:
Keramik, Kunststoff, Glas.

In einer Ausgestaltung sind die elektrischen Leiter im Bereich der Trennvorrichtung mittels eines Druck- oder Ätzverfahrens auf die Seitenflächen der Platte präpariert.

In einer Ausgestaltung sind die elektrischen Leiter auf den Seitenflächen metallisch und weisen insbesondere mindestens eines der folgenden Materialen auf:
Kupfer, Silber, Aluminium, Eisen, oder eine Legierung enthaltend mindestens eines dieser Elemente.

In einer Ausgestaltung ist eine Länge der Leiterabschnitte im Bereich der Trennvorrichtung in einem Überlappungsbereich mindestens 5 mm und insbesondere mindestens 10 mm und bevorzugt mindestens 20 mm ist und/oder
höchstens 150 mm und insbesondere höchstens 120 mm und bevorzugt höchstens 100 mm.

Insbesondere ist die Länge der Leiterabschnitte auf eine Frequenz des Datensignals angepasst.

In einer Ausgestaltung weist das Datensignal eine Frequenz von mindestens 0.25 GHz, und insbesondere mindestens 0.4 GHz, und bevorzugt mindestens 1 GHz auf, und/oder eine Frequenz von höchstens 10 GHz, und insbesondere höchstens 8 GHz, und bevorzugt höchstens 6 GHz auf.

In einer Ausgestaltung ist eine Wellenlänge des Datensignals um einen Faktor F größer ist als die Länge der Leiterabschnitte im Bereich der galvanischen Trennvorrichtung,
wobei F größer als 1 und insbesondere größer als 2 und bevorzugt größer als 3.5 ist und/oder wobei
F kleiner als 5.5 und insbesondere kleiner als 5.0 und bevorzugt kleiner als 4.5 ist.

In einer Ausgestaltung weist das Feldgerät eine Umhausung der Trennvorrichtung auf, in welcher Umhausung die Trennvorrichtung angeordnet ist, wobei die Umhausung in der ersten Signaldurchführung bzw. in der zweiten Signaldurchführung angeordnet ist, wobei eine Außenseite der Umhausung fest mit der ersten Signaldurchführung bzw. mit der zweiten Signaldurchführung verbunden ist, wobei die Trennvorrichtung in der Umhausung insbesondere mittels eines Vergusses druckfest vergossen ist.

In einer Ausgestaltung ist das Feldgerät ein Füllstands- oder Durchflussmessgerät.

Im Folgenden wird das Feldgerät anhand von Ausführungsbeispielen beschrieben.
Figs. 1 a) und 1 b) skizzieren den schematischen Aufbau jeweils eines beispielhaften erfindungsgemäßen Feldgeräts;
und Fig. 2 skizziert verschiedene Ansichten einer beispielhaften erfindungsgemäßen Trennvorrichtung;
und Figs. 3 a) und 3 b) skizzieren zwei beispielhafte Varianten einer Einrichtung einer erfindungsgemäßen Trennvorrichtung in einer Signaldurchführung des Feldgeräts.

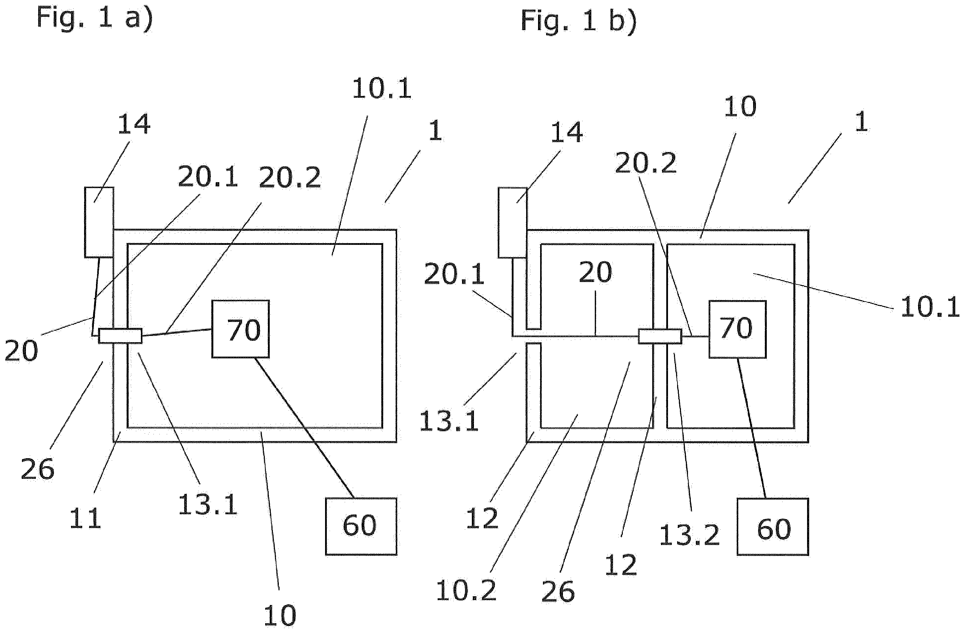

Fig. 1 a) skizziert ein Feldgerät 1 mit einem Gehäuse 10, einer elektronischen Betriebsschaltung 70, einer Messelektronik 60, einer Datenübertragungsvorrichtung 14, einer Signalleitung 20 und einer Trennvorrichtung 26. Die Messelektronik ist in einer ersten Gehäusekammer 10.1 des Gehäuses angeordnet und mit der Messelektronik über eine elektrische Verbindung gekoppelt. Die Signalleitung 20 ist dazu eingerichtet, die an einer Außenseite des Gehäuses 10 angeordnete Datenübertragungsvorrichtung 14 mit der elektronischen Betriebsschaltung 70 zu verbinden, wobei die Signalleitung durch eine erste Signaldurchführung 13.1 in einer Gehäusewand 11 geführt ist. Die Trennvorrichtung 26 ist in der ersten Signaldurchführung 13.1 angeordnet, wobei die gewählte Darstellung sehr schematisch ist und keine Rückschlüsse auf eine tatsächliche geometrische Ausgestaltung erlaubt. Ein erster Signalleitungsabschnitt 20.1 verbindet die Datenübertragungsvorrichtung 14 mit der Trennvorrichtung, und ein zweiter Signalleitungsabschnitt 20.2 verbindet die elektronische Betriebsschaltung 70 mit der Trennvorrichtung.

Die in Fig. 1 b) skizzierte Variante des Feldgeräts 1 weist eine zusätzliche zweite Gehäusekammer 10.2 auf, wobei die elektronische Betriebsschaltung 70 in der ersten Gehäusekammer angeordnet ist. Die Signalleitung 20 verläuft durch die zweite und ist einerseits durch eine zweite Signaldurchführung 13.2 in einer Innenwandung 12 des Gehäuses 10 zur elektronischen Betriebsschaltung 70 geführt und andererseits durch die erste Signaldurchführung 13.1 zur Datenübertragungsvorrichtung geführt. Die Trennvorrichtung ist hierbei in der zweiten Signaldurchführung angeordnet, kann aber auch alternativ in der ersten Signaldurchführung angeordnet sein.

Die Datenübertragungsvorrichtung wird dabei bevorzugt in einem Frequenzbereich von mindestens 0.25 GHz, und insbesondere mindestens 0.4 GHz, und bevorzugt mindestens 1 GHz aufweist, und von höchstens 10 GHz, und insbesondere höchstens 8 GHz, und bevorzugt höchstens 6 GHz betrieben.

Die in Figs. 1 a) und 1 b) gezeigte elektronische Betriebsschaltung ist dazu eingerichtet, die Datenübertragungsvorrichtung und die Messelektronik zu betreiben und ein von der Messelektronik erzeugtes Messsignal in einen Messwert zu wandeln.

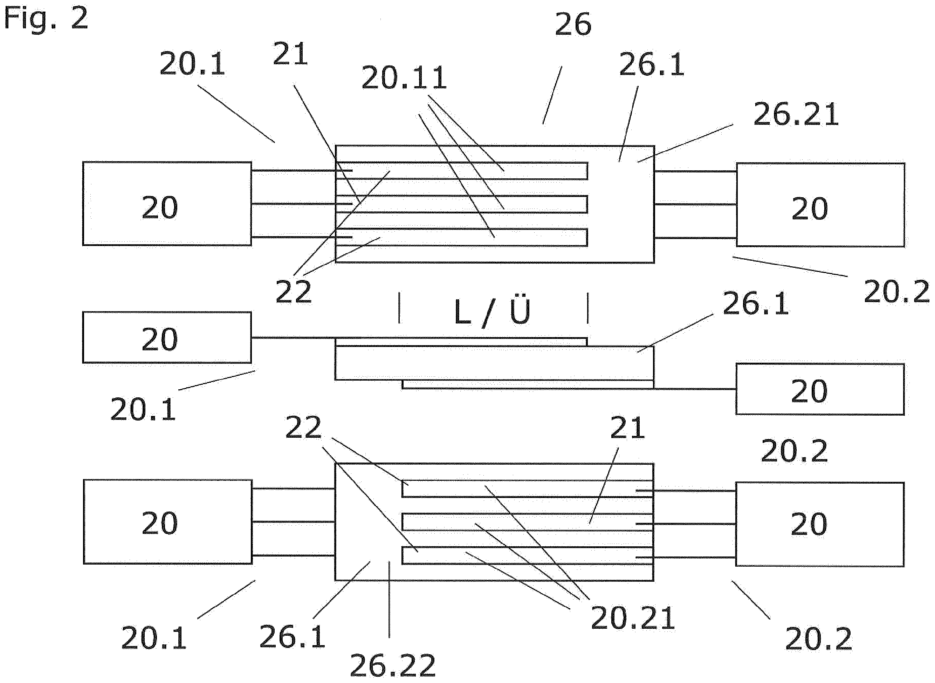

Fig. 2 zeigt eine Aufsicht (obere Skizze), eine Seitenansicht sowie eine Unteransicht der Trennvorrichtung 26. Die Trennvorrichtung weist eine elektromagnetisch transparente Platte 26.1 mit einer ersten Seitenfläche 26.21 und einer zweiten Seitenfläche 26.22 auf, wobei auf der ersten Seitenfläche Leiterabschnitte 20.11 des ersten Signalleitungsabschnitts 20.1 und wobei auf der zweiten Seitenfläche Leiterabschnitte 20.21 des zweiten Signalleitungsabschnitts 20.2 angeordnet sind. Die Signalleitung 20 ist dabei bevorzugt ein Koaxialkabel mit einem Innenleiter und einem Außenleiter bzw. Schirmung.

Ein Leiterabschnitt einer jeden Seitenfläche ist dabei ein erster Leiter 21, welcher mit der Signalleitung 20, beispielsweise mit dem Innenleiter des Koaxialkabels verbunden ist. Zwei Leiterabschnitte einer jeden Seitenfläche sind zweite Leiter 22, welcher mit der Signalleitung 20, beispielsweise mit der Schirmung bzw. dem Außenleiter des Koaxialkabels verbunden sind. Die zweiten Leiter sind auf bzgl. des ersten Leiters gegenüberliegenden Seiten angeordnet.

Die Länge L der Leiter in einem Überlappungsbereich Ü ist dabei an den Frequenzbereich des Datensignals angepasst.

Aufgrund der gegensätzlichen Richtung des Stroms des ersten Leiters in Bezug auf den Strom des mindestens einen zweiten Leiters überlagern sich die durch die Leiter erzeugten elektromagnetischen Felder im Fernfeld destruktiv, womit eine Abstrahlung der elektromagnetischen Felder ins Fernfeld erschwert und somit eine Datensignaldämpfung vermindert wird.

Die Abmessungen der gezeigten Gegenstände sind der Darstellung halber gewählt. Insbesondere sind die Höhen der Leiterabschnitte 20.11 und 20.21 in Bezug zur elektromagnetisch transparenten Platte 26.1 stark übertrieben.

Alternativ zur in Fig. 2 gezeigten Variante der Trennvorrichtung kann die Trennvorrichtung auch nur einen zweiten Leiter 22 pro Seitenfläche aufweisen, welcher neben dem entsprechenden ersten Leiter 21 angeordnet ist. Auch in diesem Falle wird eine Abstrahlung der elektromagnetischen Felder der Leiter ins Fernfeld effektiv erschwert.

Alternativ kann eine Leiterplatte auch zur erfindungsgemäßen galvanischen Trennung mehrerer Signalleitungen eingerichtet sein.

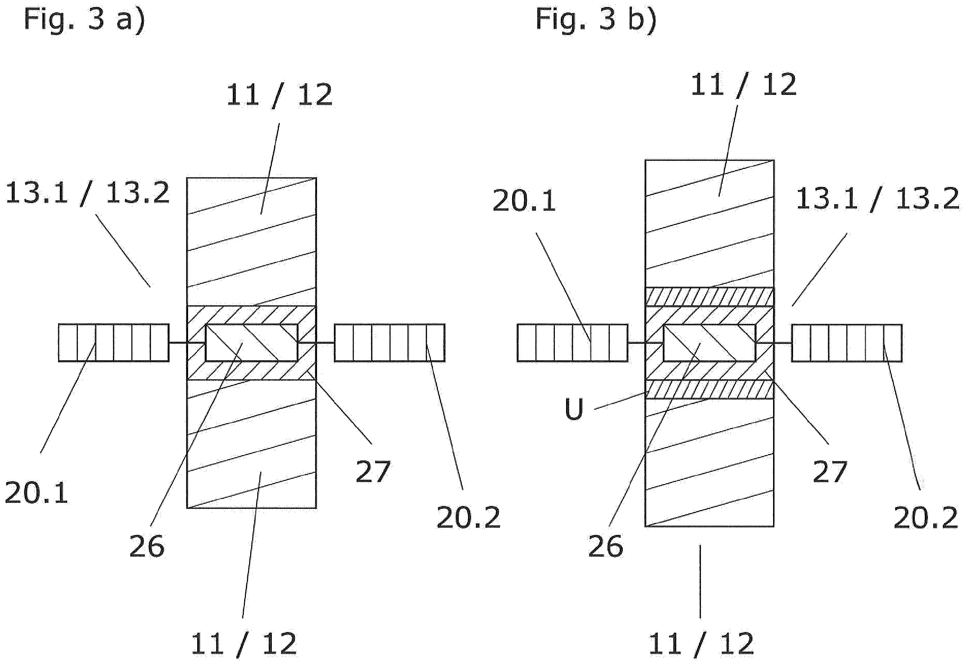

Fig. 3 skizziert beispielhafte Anordnungsmöglichkeiten der Trennvorrichtung 26 in einer Gehäusewand 11 bzw. Innenwandung 12. Fig. 3 a) zeigt eine Trennvorrichtung, welche mittels eines Vergusses 27 in der Gehäusewand 11 bzw. Innenwandung 12 festgehalten ist. Alternativ kann wie in Fig. 3b) gezeigt die Trennvorrichtung auch innerhalb einer dafür vorgesehenen Umhausung U angeordnet sein, welche Umhausung U in der Gehäusewand 11 bzw. Innenwandung 12 befestigt ist. Die Befestigung der Umhausung kann beispielsweise durch Kleben, Schweißen, Einpressen, Schrauben oder Löten erfolgen.

Alternativ zu den beiden gezeigten Ausführungsbeispielen kann die Trennungsvorrichtung auch ohne Verguss mittels anderer Befestigungsmaßnahmen 27 in der Gehäusewand 11 bzw. Innenwandung 12 bzw. der Umhausung U befestigt sein.

Auch in den Figs. 3 a) und b) dienen die gezeigten geometrischen Abmessungen und Anordnungen der Gegenstände nur der Veranschaulichung. Die elektrischen Verbindungen zwischen Trennvorrichtung 26 und dem ersten Signalleitungsabschnitt 20.1 sowie dem zweiten Signalleitungsabschnitt 20.2 sind vereinfacht dargestellt.

### Bezugszeichenliste

- 1: Feldgerät
- 10: Gehäuse
- 10.1: Erste Gehäusekammer
- 10.2: Zweite Gehäusekammer
- 11: Gehäusewand
- 12: Innenwandung
- 13.1: Erste Signaldurchführung
- 13.2: Zweite Signaldurchführung
- 14: Datenübertragungsvorrichtung
- 20: Signalleitung
- 20.1: Erster Signalleitungsabschnitt
- 20.11: Leiterabschnitt des ersten Signalleitungsabschnitts
- 20.2: Zweiter Signalleitungsabschnitt
- 20.21: Leiterabschnitt des zweiten Signalleitungsabschnitts
- 21: Erster elektrischer Leiter
- 22: Zweiter elektrischer Leiter
- 26: Trennvorrichtung
- 26.1: Elektromagnetisch transparente Platte
- 26.21: Erste Seitenfläche
- 26.22: Zweite Seitenfläche
- 27: Verguss
- 60: Messelektronik
- 70: elektronische Betriebsschaltung
- L: Länge der Leiterabschnitte
- U: Umhausung
- Ü: Überlappungsbereich

## Patentansprüche

1. Feldgerät (1) der Mess- und Automatisierungstechnik umfassend:
Ein Gehäuse (10) mit einer Gehäusewand (11) und mit mindestens einer Gehäusekammer, wobei die Gehäusekammer zumindest teilweise von der Gehäusewand umrandet ist;
eine Messelektronik (60), welche dazu eingerichtet ist, mindestens ein eine Messgröße repräsentierendes Messsignal zu erzeugen;
eine Datenübertragungsvorrichtung (14);
eine elektronische Betriebsschaltung (70), welche in einer ersten Gehäusekammer (10.1) angeordnet ist und dazu eingerichtet ist, die Datenübertragungsvorrichtung und die Messelektronik zu betreiben sowie das Messsignal in mindestens einen Messwert zu wandeln;
wobei die Datenübertragungsvorrichtung außerhalb der ersten Gehäusekammer angeordnet ist und dazu eingerichtet ist, Daten mit der elektronischen Betriebsschaltung des Feldgeräts auszutauschen;
wobei die Datenübertragungsvorrichtung und die elektronische Betriebsschaltung über eine elektrische Signalleitung (20) verbunden sind,
wobei die Signalleitung eine Mehrzahl von elektrischen Leitern aufweist, welche elektrischen Leiter dazu eingerichtet sind, ein Datensignal zwischen der Datenübertragungsvorrichtung und der elektronischen Betriebsschaltung zu übertragen,
wobei ein erster elektrischer Leiter (21) zum Führen eines das Datensignal transportierenden ersten elektrischen Stroms eingerichtet ist, und wobei mindestens ein zweiter elektrischer Leiter (22) zum Führen eines das Datensignal transportierenden zweiten elektrischen Stroms eingerichtet ist, welcher zweite elektrische Strom dem ersten elektrischen Strom entgegengesetzt ist,
wobei die Signalleitung eine Trennvorrichtung (26) aufweist, welche Trennvorrichtung dazu eingerichtet ist, einen ersten, datenübertragungsvorrichtungsseitigen Signalleitungsabschnitt (20.1) von einem zweiten, betriebselektronikseitigen Signalleitungsabschnitt (20.2) zumindest teilweise galvanisch zu trennen,
wobei jeder elektrischer Leiter einen ersten, datenübertragungsvorrichtungsseitigen Leiterabschnitt (20.11) und einen zweiten, galvanisch getrennten betriebselektronikseitigen Leiterabschnitt (20.21) aufweist, wobei die Leiterabschnitte auf der Trennvorrichtung angeordnet sind,
wobei bei mindestens einem der elektrischen Leiter der erste Leiterabschnitt (20.11) und der zweite Leiterabschnitt (20.21) galvanisch getrennt sind,
**dadurch gekennzeichnet, dass**
die Trennvorrichtung eine elektromagnetisch transparente Platte (26.1) mit einer ersten Seitenfläche (26.21) und einer zur ersten Seitenfläche parallelen zweiten Seitenfläche (26.22) aufweist,
wobei auf der Trennvorrichtung die Leiterabschnitte des ersten Signalleitungsabschnitts auf der ersten Seitenfläche angeordnet sind und wobei die Leiterabschnitte des zweiten Signalleitungsabschnitts auf der zweiten Seitenfläche angeordnet sind, wobei jeder erste Leiterabschnitt dem entsprechenden zweiten Leiterabschnitt bezüglich einer Seitenflächennormalen gegenübersteht,
wobei die Platte mindestens eine durch eine Sicherheitsnorm geforderte Mindestdicke oder Spannungsfestigkeit aufweist.

2. Feldgerät nach Anspruch 1,
wobei die Sicherheitsnorm eine Norm aus folgender Liste ist:
Gerätesicherheitsnorm IEC 60664-1 des Jahres 2007 oder Ex-d-Norm nach IEC 60079-1 des Jahres 2014, oder Ex-i-Norm nach IEC60079-11 des Jahres 2011 oder IEC 61010-1 des Jahres 2010.

3. Feldgerät nach Anspruch 1 oder 2,
wobei das Gehäuse eine zweite Gehäusekammer (10.2) aufweist, welche von der ersten Gehäusekammer durch eine Innenwandung (12) des Gehäuses getrennt ist,
wobei die Innenwandung eine zweite Signaldurchführung (13.2) aufweist, durch welche die Signalleitung verläuft.

4. Feldgerät nach einem der vorigen Ansprüche,
wobei jeder elektrische Leiter einen ersten, datenübertragungsvorrichtungsseitigen Leiterabschnitt (20.11) und einen zweiten, galvanisch getrennten betriebselektronikseitigen Leiterabschnitt (20.21) aufweist.

5. Feldgerät nach einem der vorigen Ansprüche,
wobei die Datenübertragungsvorrichtung (14) eine Antennenvorrichtung umfasst, welche dazu eingerichtet ist Hochfrequenzsignale zu empfangen und/oder zu senden,
wobei die Antennenvorrichtung auf einer Außenseite der Gehäusewand angeordnet ist,
wobei die Signalleitung durch eine erste Signaldurchführung (13.1) in der Gehäusewand verläuft.

6. Feldgerät nach einem der vorigen Ansprüche,
wobei der erste elektrische Leiter und der zweite elektrische Leiter auf den Seitenflächen parallel zueinander verlaufen,
und/oder wobei die Leiterabschnitte des ersten Signalleitungsabschnitts auf der ersten Seitenfläche parallel zu den Leiterabschnitten des zweiten Signalleitungsabschnitts auf der zweiten Seitenfläche verlaufen.

7. Feldgerät nach einem der vorigen Ansprüche,
wobei das Gehäuse und die erste Signaldurchführung bzw. die zweite Signaldurchführung druckfest nach einer Ex-d-Norm, insbesondere nach IEC 60079-1, ausgestaltet sind,
wobei die Trennvorrichtung in der ersten Signaldurchführung oder zweiten Signaldurchführung angeordnet ist und mittels eines Vergusses (27) druckfest vergossen ist.

8. Feldgerät nach einem der vorigen Ansprüche,
wobei dem ersten elektrischen Leiter (21) zwei zweite elektrische Leiter (22) zugeordnet sind, welche zweiten elektrischen Leiter bezüglich des ersten elektrischen Leiters auf gegenüberliegenden Seiten des ersten elektrischen Leiter angeordnet sind.

9. Feldgerät nach einem der vorigen Ansprüche,
wobei die Platte ein dielektrisches Material aufweist, wobei das Material insbesondere mindestens einen Stoff aus den folgenden Stoffgruppen aufweist:
Keramik, Kunststoff, Glas.

10. Feldgerät nach einem der vorigen Ansprüche,
wobei die elektrischen Leiter im Bereich der Trennvorrichtung mittels eines Druck- oder Ätzverfahrens auf die Seitenflächen der Platte präpariert sind.

11. Feldgerät nach einem der vorigen Ansprüche,
wobei die elektrischen Leiter auf den Seitenflächen metallisch sind und insbesondere mindestens eines der folgenden Materialen aufweisen:
Kupfer, Silber, Aluminium, Eisen, oder eine Legierung enthaltend mindestens eines dieser Elemente.

12. Feldgerät nach einem der vorigen Ansprüche,
wobei eine Länge (L) der Leiterabschnitte im Bereich der Trennvorrichtung in einem Überlappungsbereich (Ü) mindestens 5 mm und insbesondere mindestens 10 mm und bevorzugt mindestens 20 mm ist und/oder wobei
eine Länge( L) der Leiterabschnitte im Bereich der Trennvorrichtung höchstens 150 mm und insbesondere höchstens 120 mm und bevorzugt höchstens 100 mm ist.

13. Feldgerät nach einem der vorigen Ansprüche,
wobei das Datensignal eine Frequenz von mindestens 0.25 GHz, und insbesondere mindestens 0.4 GHz, und bevorzugt mindestens 1 GHz aufweist, und/oder
von höchstens 10 GHz, und insbesondere höchstens 8 GHz, und bevorzugt höchstens 6 GHz aufweist.

14. Feldgerät nach einem der Ansprüche 12 oder 13,
wobei eine Wellenlänge des Datensignals um einen Faktor F größer ist als die Länge (L) der Leiterabschnitte im Bereich der galvanischen Trennvorrichtung,
wobei F größer als 1 und insbesondere größer als 2 und bevorzugt größer als 3.5 ist und/oder wobei
F kleiner als 5.5 und insbesondere kleiner als 5.0 und bevorzugt kleiner als 4.5 ist.

15. Feldgerät nach einem der vorigen Ansprüche,
wobei das Feldgerät eine Umhausung (U) der Trennvorrichtung aufweist, in welcher Umhausung (U) die Trennvorrichtung angeordnet ist,
wobei die Umhausung in der ersten Signaldurchführung bzw. in der zweiten Signaldurchführung angeordnet ist,
wobei eine Außenseite der Umhausung fest mit der ersten Signaldurchführung bzw. mit der zweiten Signaldurchführung verbunden ist,
wobei die Trennvorrichtung in der Umhausung insbesondere mittels eines Vergusses (27) druckfest vergossen ist.

## Claims

1. Field device (1) used in measuring and automation engineering, wherein said device comprises:
a housing (10) with a housing wall (11) and with at least a housing chamber, wherein the housing chamber is at least partially surrounded by the housing wall;
a measuring electronics unit (60), which is designed to generate at least a measuring signal representing a measured variable;
a data transmission unit (14);
an electronic operating circuit (70), which is arranged in a first housing chamber (10.1) and is designed to operate the data transmission unit and the measuring electronics unit, and to convert the measuring signal to at least a measured value;
wherein the data transmission unit is arranged outside the first housing chamber and is designed to exchange data with the electronic operating circuit of the field device;
wherein the data transmission unit and the electronic operating circuit are connected via an electrical signal cable (20),
wherein the signal cable has multiple electric conductors, said electric conductors being designed to transmit a data signal between the data transmission unit and the electronic operating circuit,
wherein a first electric conductor (21) is designed to carry a first electric current transporting the data signal, and wherein at least a second electric conductor (22) is designed to carry a second electric current transporting the data signal, wherein said second electric current is opposed to the first electric current,
wherein the signal cable has a disconnecting device (26), wherein said disconnecting device is designed to galvanically separate, at least partially, a first signal cable section (20.1) on the data transmission unit side from a second signal cable section (20.2) on the operating electronics side,
wherein each electric conductor has a first conductor section (20.11) on the data transmission unit side and a second galvanically isolated conductor section (20.21) on the operating electronics side, wherein the conductor sections are arranged on the disconnecting device,
wherein the first conductor section (20.11) and the second conductor section (20.21) are galvanically isolated for at least one of the electric conductors,
**characterized in that**
the disconnecting device has an electromagnetically transparent plate (26.1) with a first side surface (26.21) and a second side surface (26.22) parallel to the first side surface,
wherein, on the disconnecting device, the conductor sections of the first signal cable section are arranged on the first side surface and wherein the conductor sections of the second signal cable section are arranged on the second side surface, wherein each first conductor section is opposite the corresponding second conductor section in relation to a side surface normal,
wherein the plate has at least a minimum thickness or a dielectric strength required by a safety standard.

2. Field device as claimed in Claim 1,
wherein the safety standard is a standard from the following list:
Device safety standard IEC 60664-1 of the year 2007 or the Ex-d standard according to IEC 60079-1 of the year 2014, or the Ex-i standard according to IEC 60079-1 1 of the year 2011 or IEC 61010-1 of the year 2010.

3. Field device as claimed in Claim 1 or 2,
wherein the housing has a second housing chamber (10.2), wherein said second chamber is separated from the first housing chamber by an inner wall (12) of the housing,
wherein the inner wall has a second signal feedthrough (13.2) through which the signal cable runs.

4. Field device as claimed in one of the previous claims,
wherein each electric conductor has a first conductor section (20.11) on the data transmission unit side and a second galvanically isolated conductor section (20.21) on the operating electronics side.

5. Field device as claimed in one of the previous claims,
wherein the data transmission unit (14) has an antenna unit, wherein said antenna unit is designed to receive and/or transmit high-frequency signals,
wherein the antenna unit is arranged on an outside of the housing wall,
wherein the signal cable passes through a first signal feedthrough (13.1) in the housing wall.

6. Field device as claimed in one of the previous claims,
wherein the first electric conductor and the second electric conductor are parallel to one another on the side surfaces,
and/or wherein the conductor sections of the first signal cable section on the first side surface are parallel to the conductor sections of the second signal cable section on the second side surface.

7. Field device as claimed in one of the previous claims,
wherein the housing and the first signal feedthrough or the second signal feedthrough are designed to be pressure-tight according to an Ex-d standard, particularly according to the IEC 60079-1 standard,
wherein the disconnecting device is arranged in the first signal feedthrough or the second signal feedthrough and is potted in a pressure-tight manner by means of a potting (27).

8. Field device as claimed in one of the previous claims,
wherein two second electric conductors (22) are assigned to the first electric conductor (21), wherein, in relation to the first electric conductor, said second electric conductors are arranged on opposite sides of the first electric conductor.

9. Field device as claimed in one of the previous claims,
wherein the plate has a dielectric material, wherein the material particularly features at least one substance from the following groups of substances:
ceramic, plastic, glass.

10. Field device as claimed in one of the previous claims,
wherein the electric conductors are prepared in the area of the disconnecting device by means of a printing or engraving process on the side surfaces of the plate.

11. Field device as claimed in one of the previous claims,
wherein the electric conductors on the side surfaces are metal and particularly feature at least one of the following materials:
copper, silver, aluminum, iron or an alloy containing at least one of these elements.

12. Field device as claimed in one of the previous claims,
wherein a length (L) of the conductor sections in the area of the disconnecting device in an overlapping area (Ü) is at least 5 mm and particularly at least 10 mm and preferably at least 20 mm and/or
wherein a length (L) of the conductor sections in the area of the disconnecting device is at maximum 150 mm and particularly at maximum 120 mm and preferably at maximum 100 mm.

13. Field device as claimed in one of the previous claims,
wherein the data signal has a frequency of at least 0.25 GHz and particularly of at least 0.4 GHz and preferably of at least 1 GHz, and/or
a frequency of at most 10 GHz and particularly at most 8 GHz and preferably at most 6 GHz.

14. Field device as claimed in one of the Claims 12 or 13,
wherein a wave length of the data signal is greater than the length (L) of the conductor sections by a factor F in the area of the galvanic disconnecting device,
wherein F is greater than 1 and particularly greater than 2 and preferably greater than 3.5 and/or
wherein F is less than 5.5 and particularly less than 5.0 and preferably less than 4.5.

15. Field device as claimed in one of the previous claims,
wherein the field device has an enclosure (U) of the disconnecting device, wherein the disconnecting device is arranged in said enclosure (U),
wherein the enclosure is arranged in the first signal feedthrough or in the second signal feedthrough,
wherein an outer side of the enclosure is connected in a fixed manner with the first signal feedthrough or the second signal feedthrough,
wherein the disconnecting device is potted in a pressure-tight manner in the enclosure, particularly by means of a potting (27).

## Revendications

1. Appareil de terrain (1) de la technique de mesure et d'automatisation, lequel appareil comprend :
un boîtier (10) avec une paroi de boîtier (11) et avec au moins une chambre de boîtier, la chambre de boîtier étant au moins partiellement entourée par la paroi de boîtier ;
une électronique de mesure (60), laquelle est conçue pour générer au moins un signal de mesure représentant une grandeur de mesure ;
un dispositif de transmission de données (14) ;
un circuit d'exploitation électronique (70), lequel est disposé dans une première chambre de boîtier (10.1) et est conçu pour exploiter le dispositif de transmission de données et l'électronique de mesure, ainsi que pour convertir le signal de mesure en au moins une valeur mesurée ;
le dispositif de transmission de données étant disposé à l'extérieur de la première chambre de boîtier et étant conçu pour échanger des données avec le circuit d'exploitation électronique de l'appareil de terrain ;
le dispositif de transmission de données et le circuit d'exploitation électronique étant reliés par le biais d'un câble de signal électrique (20),
le câble de signal comprenant une pluralité de conducteurs électriques, lesquels conducteurs électriques sont conçus pour transmettre un signal de données entre le dispositif de transmission de données et le circuit d'exploitation électronique,
un premier conducteur électrique (21) étant conçu pour conduire un premier courant électrique transportant le signal de données, et au moins un deuxième conducteur électrique (22) étant conçu pour conduire un deuxième courant électrique transportant le signal de données, lequel deuxième courant électrique est opposé au premier courant électrique,
le câble de signal comprenant un dispositif de séparation (26), lequel dispositif de séparation est conçu pour séparer galvaniquement, au moins partiellement, une première section de câble de signal (20.1) côté dispositif de transmission de données d'une deuxième section de câble de signal (20.2) côté électronique d'exploitation,
chaque conducteur électrique présentant une première section de conducteur (20.11) côté dispositif de transmission de données et une deuxième section de conducteur (20.21) séparée galvaniquement côté électronique d'exploitation, les sections de conducteur étant disposées sur le dispositif de séparation,
la première section de conducteur (20.11) et la deuxième section de conducteur (20.21) étant séparées galvaniquement pour au moins l'un des conducteurs électriques,
**caractérisé en ce que**
le dispositif de séparation comprend une plaque électromagnétique transparente (26.1) présentant une première surface latérale (26.21) et une deuxième surface latérale (26.22) parallèle à la première surface latérale,
les sections de conducteur de la première section de câble de signal étant disposées, au niveau du dispositif de séparation, sur la première surface latérale et les sections de conducteur de la deuxième section de câble de signal étant disposées, au niveau du dispositif de séparation, sur la deuxième surface latérale, chaque première section de conducteur étant opposée à la deuxième section de conducteur correspondante par rapport à une normale à la surface latérale,
la plaque présentant au moins une épaisseur minimale ou une résistance diélectrique requise par une norme de sécurité.

2. Appareil de terrain selon la revendication 1,
pour lequel la norme de sécurité est une norme de la liste suivante :
Norme de sécurité d'appareil IEC 60664-1 de l'année 2007 ou norme Ex-d selon IEC 60079-1 de l'année 2014, ou norme Ex-i selon IEC 60079-1 1 de l'année 2011 ou IEC 61010-1 de l'année 2010.

3. Appareil de terrain selon la revendication 1 ou 2,
pour lequel le boîtier présente une deuxième chambre de boîtier (10.2), laquelle deuxième chambre est séparée de la première chambre de boîtier par une paroi intérieure (12) du boîtier,
la paroi intérieure présentant une deuxième traversée de signal (13.2) à travers laquelle s'étend le câble de signal.

4. Appareil de terrain selon l'une des revendications précédentes,
pour lequel chaque conducteur électrique présente une première section de conducteur (20.11) côté dispositif de transmission de données et une deuxième section de conducteur (20.21) séparée galvaniquement, côté électronique d'exploitation.

5. Appareil de terrain selon l'une des revendications précédentes,
pour lequel le dispositif de transmission de données (14) comprend un dispositif d'antenne, lequel dispositif d'antenne est conçu pour recevoir et/ou émettre des signaux haute fréquence,
le dispositif d'antenne étant disposé sur une face extérieure de la paroi du boîtier,
le câble de signal passant par une première traversée de signal (13.1) dans la paroi du boîtier.

6. Appareil de terrain selon l'une des revendications précédentes,
pour lequel le premier conducteur électrique et le deuxième conducteur électrique sont parallèles entre eux sur les surfaces latérales,
et/ou pour lequel les sections de conducteur de la première section de câble de signal sur la première surface latérale sont parallèles aux sections de conducteur de la deuxième section de câble de signal sur la deuxième surface latérale.

7. Appareil de terrain selon l'une des revendications précédentes,
pour lequel le boîtier et la première traversée de signal ou la deuxième traversée de signal sont conçus pour résister à la pression selon une norme Ex-d, notamment selon la norme IEC 60079-1 ,
pour lequel le dispositif de séparation est disposé dans la première traversée de signal ou la deuxième traversée de signal et est scellé de manière résistante à la pression au moyen d'un surmoulage (27).

8. Appareil de terrain selon l'une des revendications précédentes,
pour lequel deux deuxièmes conducteurs électriques (22) sont associés au premier conducteur électrique (21), lesquels deuxièmes conducteurs électriques sont disposés sur des côtés opposés du premier conducteur électrique par rapport au premier conducteur électrique.

9. Appareil de terrain selon l'une des revendications précédentes,
pour lequel la plaque comprend un matériau diélectrique, ledit matériau comprenant notamment au moins une matière appartenant aux groupes de matières suivants :
céramique, plastique, verre.

10. Appareil de terrain selon l'une des revendications précédentes,
pour lequel les conducteurs électriques sont préparés dans la zone du dispositif de séparation au moyen d'un procédé d'impression ou de gravure sur les surfaces latérales de la plaque.

11. Appareil de terrain selon l'une des revendications précédentes,
pour lequel les conducteurs électriques sur les surfaces latérales sont métalliques et présentent notamment au moins l'une des matières suivantes :
cuivre, argent, aluminium, fer ou un alliage contenant au moins un de ces éléments.

12. Appareil de terrain selon l'une des revendications précédentes,
pour lequel une longueur (L) des sections de conducteur dans la zone du dispositif de séparation dans une zone de chevauchement (Ü) est d'au moins 5 mm et notamment d'au moins 10 mm et de préférence d'au moins 20 mm et/ou
pour lequel une longueur (L) des sections de conducteur dans la zone du dispositif de séparation est au maximum de 150 mm et notamment au maximum de 120 mm et de préférence au maximum de 100 mm.

13. Appareil de terrain selon l'une des revendications précédentes,
pour lequel le signal de données présente une fréquence d'au moins 0,25 GHz et notamment d'au moins 0,4 GHz et de préférence d'au moins 1 GHz, et/ou
une fréquence d'au plus 10 GHz et notamment d'au plus 8 GHz et de préférence d'au plus 6 GHz.

14. Appareil de terrain selon l'une des revendications 12 ou 13,
pour lequel une longueur d'onde du signal de données est supérieure d'un facteur F à la longueur (L) des sections de conducteur dans la zone du dispositif de séparation galvanique,
F étant supérieur à 1 et notamment supérieur à 2 et de préférence supérieur à 3,5 et/ou
F étant inférieur à 5,5 et notamment inférieur à 5,0 et de préférence inférieur à 4,5.

15. Appareil de terrain selon l'une des revendications précédentes,
l'appareil de terrain présentant une enceinte (U) du dispositif de séparation, enceinte (U) dans laquelle le dispositif de séparation est disposé,
l'enceinte étant disposée dans la première traversée de signal ou dans la deuxième traversée de signal,
un côté extérieur de l'enceinte étant relié de manière fixe à la première traversée de signal ou à la deuxième traversée de signal,
le dispositif de séparation étant scellé dans l'enceinte de manière à résister à la pression, notamment au moyen d'un surmoulage (27).
